# EUROPEAN PATENT APPLICATION

(11) **EP 4 810 979 A1**
(43) Date of publication of application: **23.09.2026**
(21) Application number: 26166137.5
(22) Date of filing: 19.03.2026
(51) Int. Cl.: G01R 33/3415, G01R 33/36

(54) **WIRELESS COILS, MAGNETIC RESONANCE IMAGING SYSTEMS INCLUDING THE SAME, AND CONTROL METHODS FOR THE MAGNETIC RESONANCE IMAGING SYSTEMS**

(30) Priority: 19.03.2025 CN 202510333221
(71) Applicant: Shanghai United Imaging Healthcare Co., Ltd., Shanghai 201807 (CN)
(72) Inventor: YANG, Tingzhao, Shanghai, 201807 (CN); WU, Bing, Shanghai, 201807 (CN); FANG, Fuyi, Shanghai, 201807 (CN); FAN, Xianwen, Shanghai, 201807 (CN); SHANG, Haifang, Shanghai, 201807 (CN)
(74) Representative: Wang, Bo

(57) **Abstract**

A wireless coil applied to an MRI system is provided. The MRI system includes a transmitting coil having a housing cavity. The wireless coil includes: a flexible member and one or more magnetic coupling units, disposed on a surface of or inside the flexible member, wherein the wireless coil and the transmitting coil are respectively separated from each other in a radial direction of the housing cavity, and the wireless coil is capable of resonating under a radio frequency field generated by the transmitting coil of the MRI system to produce a focal field. A coverage area of the focal field is smaller than a coverage area of the radio frequency field.

## Description

### CROSS-REFERENCE TO RELATED APPLICATIONS

This application claims priority to the Chinese Patent Application No. 202510333221.9, filed on March 19, 2025.

### TECHNICAL FIELD

The present disclosure relates to the field of magnetic resonance, and in particular to a wireless coil, a magnetic resonance imaging (MRI) system including the same, and a control method for the MRI system.

### BACKGROUND

In a high-field-strength magnetic resonance imaging environment, as the wavelength of a radio frequency field (also referred to as a B1 field) shortens with increasing field strength, a standing wave effect becomes significant, leading to uneven spatial distribution of an electromagnetic field, which in turn affects image quality and, in severe cases, results in dark bands. Particularly in scenarios requiring deep imaging, such as head imaging and abdominal imaging, when an imaging depth exceeds a wavelength of an electromagnetic wave generated by a radio frequency coil, the dark bands formed in the radio frequency field due to the standing wave effect are difficult to eliminate through radio frequency field shimming techniques, thereby producing obvious artifacts in an MRI image.

Therefore, it is necessary to provide a wireless coil, an MRI system including the same, and a control method for the MRI system to enhance a magnetic field in specific areas, change the distribution of a transmitting field, thereby improving the uniformity of the radio frequency field and effectively enhancing image quality in high-field-strength imaging.

### SUMMARY

One or more embodiments of the present disclosure provide a wireless coil applied to an MRI system. The MRI system includes a transmitting coil having a housing cavity. The wireless coil includes a flexible member and one or more magnetic coupling units, disposed on a surface of or inside the flexible member. The wireless coil and the transmitting coil are respectively separated from each other in a radial direction of the housing cavity. The wireless coil is capable of resonating under a radio frequency field generated by the transmitting coil of the MRI system to produce a focal field. A coverage area of the focal field is smaller than a coverage area of the radio frequency field.

In some embodiments, two adjacent magnetic coupling units among the one or more magnetic coupling units partially overlap.

In some embodiments, a diameter of each magnetic coupling unit among the one or more magnetic coupling units is in a range of 5 cm to 20 cm.

In some embodiments, the flexible member is a wearable flexible member, and a shape of the wearable flexible member matches a facial contour of a subject to be scanned using the MRI system.

In some embodiments, in a state where the wearable flexible member is worn on a face of the subject, the one or more magnetic coupling units cover an oral region of the subject.

In some embodiments, the wireless coil further includes an insulating spacer disposed in an overlapping region of two adjacent magnetic coupling units among the one or more magnetic coupling units.

In some embodiments, each of the one or more magnetic coupling units is further provided with one or more tuning elements, the one or more tuning elements enabling the each of the one or more magnetic coupling units to resonate at a frequency of the radio frequency field.

In some embodiments, the one or more tuning elements of one of the one or more magnetic coupling units are uniformly arranged along the one of the one or more magnetic coupling units.

In some embodiments, each of the one or more magnetic coupling units is further provided with a protection device, and the protection device is configured to control the each of the one or more magnetic coupling units to detune when an induced current on the each of the one or more magnetic coupling units exceeds a preset current range.

In some embodiments, the wireless coil further includes an external interface configured to enable the protection device to control the each of the one or more magnetic coupling units to detune in a wired connection manner

In some embodiments, the flexible member covers an abdomen of a subject to be scanned using the MRI system, the one or more magnetic coupling units are arranged in two rows along a head-to-foot direction of the subject, and each of the two rows includes three magnetic coupling units arranged adjacent to each other from left to right.

In some embodiments, each of the one or more magnetic coupling units is further provided with a protection device, and the protection device is configured to control the each of the one or more magnetic coupling units to switch from a resonant state to a detuned state when a temperature of the each of the one or more magnetic coupling units exceeds a set threshold.

One or more embodiments of the present disclosure provide an MRI system. The MRI system includes a support cylinder providing an accommodation cavity, the accommodation cavity being configured to accommodate a subject; a transmitting coil, disposed on the support cylinder and located on an outer surface of the support cylinder, for generating a radio frequency field; a flexible member, capable of covering an organ or tissue of the subject; and one or more magnetic coupling units, disposed on the flexible member; wherein the one or more magnetic coupling units are capable of resonating under the radio frequency field to produce a focal field.

In some embodiments, the flexible member is configured to adhere to at least one of an abdomen, a chest, or a face of the subject, or the flexible member is configured to wrap at least one of a head, a knee joint, or an ankle of the subject.

In some embodiments, each of the one or more magnetic coupling units is further provided with a protection device, the protection device is configured to control the each of the one or more magnetic coupling to switch from a resonant state to a detuned state when a temperature of the each of the one or more magnetic coupling units exceeds a set threshold.

One or more embodiments of the present disclosure provide a control method for an MRI system. The MRI system includes a transmitting coil and a wireless coil, the transmitting coil and the wireless coil being disposed separately from each other, and the wireless coil being capable of covering at least a portion of a subject. The control method includes controlling the transmitting coil to be in a transmission mode to transmit a radio frequency field to the subject; controlling the wireless coil to resonate under the radio frequency field to produce a focal field, the focal field being configured to excite nuclei of an organ or tissue of the subject; and controlling the transmitting coil to be in a reception mode to receive a magnetic resonance signal from the organ or tissue of the subject.

In some embodiments, the wireless coil includes one or more magnetic coupling units, and the one or more magnetic coupling units are distributed in rows and columns to form an array structure; the wireless coil is configured to adhere to at least one of an abdomen, a chest, or a face of the subject, or the wireless coil is configured to wrap at least one of a head, a knee joint, or an ankle of the subject.

In some embodiments, controlling the transmitting coil to be in a transmission mode to transmit a radio frequency field to the examination subject includes controlling each of the one or more magnetic coupling units to detune via a protection device of the each of the one or more magnetic coupling units.

In some embodiments, controlling each of the one or more magnetic coupling units to detune via a protection device of the each of the one or more magnetic coupling units includes enabling the protection device to control the each of the one or more magnetic coupling units to detune in a wired connection manner via an external interface provided on the wireless coil.

In some embodiments, the control method further includes monitoring a temperature of the wireless coil, and in response to a determination that the temperature of the wireless coil exceeds a set threshold, controlling the wireless coil to switch from a resonant state to a detuned state.

Additional features will be set forth in part in the description which follows, and in part will become apparent to those skilled in the art upon examination of the following and the accompanying drawings, or may be learned by production or operation of the examples. The features of the present disclosure may be realized and attained by practice or use of various aspects of the methodologies, instrumentalities, and combinations set forth in the detailed examples discussed below.

### BRIEF DESCRIPTION OF THE DRAWINGS

The present disclosure is further described by way of exemplary embodiments. These exemplary embodiments are described in detail with reference to the accompanying drawings. These embodiments are nonlimiting. In these embodiments, the same numerals refer to the same structures, wherein:
FIG. 1 is a schematic diagram illustrating an exemplary wireless coil according to some embodiments of the present disclosure;
FIG. 2 is a schematic diagram illustrating a state where a wearable flexible member is worn on the face of a body according to some embodiments of the present disclosure;
FIG. 3 is a schematic diagram illustrating another exemplary wireless coil according to some embodiments of the present disclosure;
FIG. 4 is a schematic diagram illustrating the wireless coil shown in FIG. 3 from another perspective;
FIG. 5 is a schematic diagram illustrating a cross-sectional view of a wireless coil according to some embodiments of the present disclosure;
FIG. 6 is a schematic diagram illustrating a wireless coil during a water phantom test according to some embodiments of the present disclosure;
FIG. 7A is a schematic diagram illustrating one or more tuning elements and a protection device according to some embodiments of the present disclosure;
FIG. 7B is a schematic diagram illustrating a structure of a detuned circuit according to some embodiments of the present disclosure;
FIG. 8A is an image of a B1 field result when a transmitting coil performs radio frequency signal transmission and reception without using a wireless coil;
FIG. 8B is an image of a B1 field result when a transmitting coil performs radio frequency signal transmission and reception with an application of a wireless coil;
FIG. 9A is a result image of a gradient-recalled echo quick sequence (GRE_quick sequence) without using a wireless coil;
FIG. 9B is a result image of a GRE_quick sequence with an application of a wireless coil;
FIG. 10A is a schematic diagram illustrating a subject entering an MRI system along a head-to-foot direction according to some embodiments of the present disclosure;
FIG. 10B is a schematic diagram illustrating an arrangement of one or more magnetic coupling units in a wireless coil along a head-to-foot direction of a subject according to some embodiments of the present disclosure;
FIG. 11 is a schematic diagram illustrating a distribution of a support cylinder and a transmitting coil according to some embodiments of the present disclosure;
FIG. 12 is a schematic diagram illustrating a flexible member covering an abdomen of a subject according to some embodiments of the present disclosure;
FIG. 13 is a flowchart illustrating an exemplary process of a control method for an MRI system according to some embodiments of the present disclosure; and
FIG. 14 is a flowchart illustrating another exemplary process of a control method for an MRI system according to some embodiments of the present disclosure.

### DETAILED DESCRIPTION

To more clearly illustrate the technical solutions related to the embodiments of the present disclosure, a brief introduction of the drawings referred to the description of the embodiments is provided below. Obviously, the drawings described below are only some examples or embodiments of the present disclosure. Those having ordinary skills in the art, without further creative efforts, may apply the present disclosure to other similar scenarios according to these drawings. Unless obviously obtained from the context or the context illustrates otherwise, the same numeral in the drawings refers to the same structure or operation.

It should be understood that "system," "device," "unit," and/or "module" as used herein is a manner used to distinguish different components, elements, parts, sections, or assemblies at different levels. However, if other words serve the same purpose, the words may be replaced by other expressions.

As shown in the present disclosure and claims, the words "one," "a," "a kind," and/or "the" are not especially singular but may include the plural unless the context expressly suggests otherwise. In general, the terms "comprise," "comprises," "comprising," "include," "includes," and/or "including," merely prompt to include operations and elements that have been clearly identified, and these operations and elements do not constitute an exclusive listing. The methods or devices may also include other operations or elements.

It will be understood that, although the terms "first," "second," "third," "fourth," etc., may be used herein to describe various elements, these elements should not be limited by these terms. These terms are only used to distinguish one element from another. For example, a first element could be termed a second element, and, similarly, a second element could be termed a first element, without departing from the scope of example embodiments of the present invention.

The flow charts used in the present disclosure illustrate operations that systems implement according to some embodiments of the present disclosure. It should be understood that the previous or subsequent operations may not be accurately implemented in order. Instead, each step may be processed in reverse order or simultaneously. Meanwhile, other operations may also be added to these processes, or a certain step or several steps may be removed from these processes.

For illustration purposes, the following description is provided to help better understand a wireless coil, an MRI system, and a control method for the MRI system. It is understood that this is not intended to limit the scope of the present disclosure. For persons having ordinary skills in the art, a certain amount of variations, changes, and/or modifications may be deducted under the guidance of the present disclosure. Those variations, changes and/or modifications do not depart from the scope of the present disclosure.

For an MRI system, during high-magnetic-field scanning, the inhomogeneity of a radio frequency field (also referred to as B1 field) caused by a standing wave directly affects final image quality. Even after shimming and sequence optimization, field inhomogeneity and obvious dark bands may persist. Especially in long-distance imaging applications (e.g., abdominal imaging, head imaging), the image artifacts caused by the dark bands become more pronounced. The standing wave effect is a physical phenomenon resulting from increased field strength, making it difficult to mitigate by optimizing the structure of the MRI system's own coils. The inhomogeneity of the B1 field caused by the standing wave effect also imposes limitations on shimming sequences.

A transmitting coil refers to a radio frequency coil used for transmitting radio frequency pulses. In some embodiments, the transmitting coil may also serve as a receiving coil in a receive mode. That is, when the transmitting coil is in the receive mode, it receives a magnetic resonance signal. When the transmitting coil is in a transmission mode, it may transmit the radio frequency pulses to generate a radio frequency field.

The B1 field refers to an alternating magnetic field emitted by the transmitting coil, configured to cause atomic nuclei (e.g., hydrogen nuclei) in the human body to undergo magnetic resonance.

The transmitting coil may be a volume transmitting coil or a local transceiver coil.

In some embodiments, the transmitting coil may be a birdcage coil, which may be connected to a switch tube and a mode switching circuit. The mode switching circuit is configured to control the birdcage coil to be in the transmission mode or the receive mode. The switch tube is configured to control the resonance or detuning of the birdcage coil in the transmission mode.

When the switch tube is off, the birdcage coil is detuned, and the switch tube exhibits parasitic capacitance. The parasitic capacitance causes a signal leakage from the transmitting coil. The signal leakage from the transmitting coil increases as the frequency of the radio frequency field generated by the transmitting coil rises. In high-frequency applications, parasitic capacitance may rapidly deteriorate the switch tube's cutoff characteristic. In the transmitting coil provided in some embodiments of the present disclosure, a detuning circuit is provided, and the detuning circuit is connected in parallel across the switch tube. The detuning circuit is configured to suppress or even cancel the parasitic capacitance generated when the switch tube is turned off, improving the cut-off characteristic of the switch tube, thereby enhancing the detuning isolation of the transmitting coil. The higher the detuning isolation of the transmitting coil, the better the quality of the received signal.

When the transmitting coil is in a tuned state, it is configured to receive a driving signal from a radio frequency power amplifier to transmit radio frequency pulses to the exterior, thereby generating a radio frequency field. At the same time, the wireless coil resonates under the radio frequency field to produce a focal field, and the focal field is configured to excite nuclei of an organ or a tissue of a subject.

The wireless coil is a passive resonant structure that does not directly receive the magnetic resonance signal. Instead, it resonates under the radio frequency field generated by the transmitting coil, producing a locally enhanced magnetic field (i.e., the focal field), which is configured to optimize the distribution of the B1 field, and suppress the dark bands.

The focal field refers to a secondary magnetic field generated by the wireless coil through resonance when excited by the radio frequency field of the transmitting coil.

The birdcage coil includes a first end ring, a second end ring, and a plurality of legs. The second end ring is spaced apart and opposite the first end ring. One end of each of the plurality of legs is connected to the first end ring. The other end of each of the plurality of legs is connected to the second end ring. The plurality of legs are distributed along a circumferential direction of the first end ring or the second end ring.

In some embodiments, the transmitting coil may be a degenerate birdcage coil. The degenerate birdcage coil includes a plurality of rung portions and two end portions. The plurality of rung portions are provided with one or more rung antennas, and each of the two end portions is provided with one or more end ring antennas. The end portions are arranged at both ends of each rung portion, as well as at positions between two adjacent rung portions near the ends. Each of the plurality of rung portions is connected to the two end portions at the two ends of the rung portion. The plurality of rung portions are spaced apart (preferably evenly spaced) along a circumference of the transmitting coil, and the each of the plurality of rung portions extends along an axial direction of the transmitting coil. The each of the plurality of rung portions includes a plurality of rung subunits arranged adjacent to each other sequentially along the axial direction of the transmitting coil. Two adjacent rung subunits are connected via a capacitor. Typically, two adjacent rung subunits located in the middle region of the each of the plurality of rung portions are connected via a fixed capacitor, while two adjacent rung subunits near an end region of the each of the plurality of rung portions, or a rung subunit used for connection with an end portion and the adjacent rung subunit of the rung subunit are connected via an adjustable capacitor (i.e., a capacitor whose capacitance value may be adjusted). This arrangement allows the errors of each fixed capacitor to be corrected by the adjustable capacitor, thereby achieving precise frequency calibration. Furthermore, each of the plurality of rung portions includes a plurality of end subunits, and the plurality of end subunits are spaced apart along the circumference of the transmitting coil, thus forming a ring-shaped end portion.

The two adjacent rung portions, together with a plurality of end subunits located between the two adjacent rung portions, form a loop. It may be seen that the transmitting coil includes a plurality of loops arranged along the circumference of the transmitting coil, and the count of the plurality of loops equals the count of the plurality of rung portions of the transmitting coil. The amplitude and the phase of a driving signal for each loop may be set independently.

In some embodiments, the transmitting coil may be an array coil composed of a plurality of loop coils. The plurality of loop coils is arranged around a cylindrical support. The plurality of loop coils has neither geometric overlap nor physical structural connection with each other and are configured to generate a circularly polarized transmitting field.

As the field strength of an MRI system further increases, the impact of this phenomenon on the image quality will become more prominent. For example, in 5T abdominal imaging, artifacts caused by two dark bands at the top portion and the bottom portion of the image seriously interfere with a doctor's diagnosis. Furthermore, due to differences in patient body types and imaging sites, the distance between an imaging region and the magnet varies widely, making it difficult to maintain a uniform radio frequency field and further degrading image quality. Currently the radio frequency coil mostly adopts small-size, large-array designs to improve imaging acceleration capability. However, the improvement in penetration depth gained by sacrificing coil size still struggles to solve the dark band problem in deep regions. Shimming methods that rely solely on amplitude and phase adjustment have a limited effect because the dark bands mainly originate from inherent defects in the distribution of the radio frequency field.

To address the above problems, some embodiments of the present disclosure provide a wireless coil applied to an MRI system. The MRI system includes a transmitting coil having a housing cavity. The wireless coil and the transmitting coil are respectively separated from each other in a radial direction of the housing cavity.

The housing cavity refers to an internal space within the transmitting coil of the MRI system, designed to accommodate a subject (e.g., a patient's body part). It is typically cylindrical and may be constructed from a material that is transparent to the radio frequency field, such as fiberglass or engineering plastic.

The radial direction of the housing cavity is a direction perpendicular to a central axis of the housing cavity, pointing from a center of the housing cavity towards its outer wall. The radial direction of the housing cavity is used to specify the relative spatial positioning between the wireless coil and the transmitting coil.

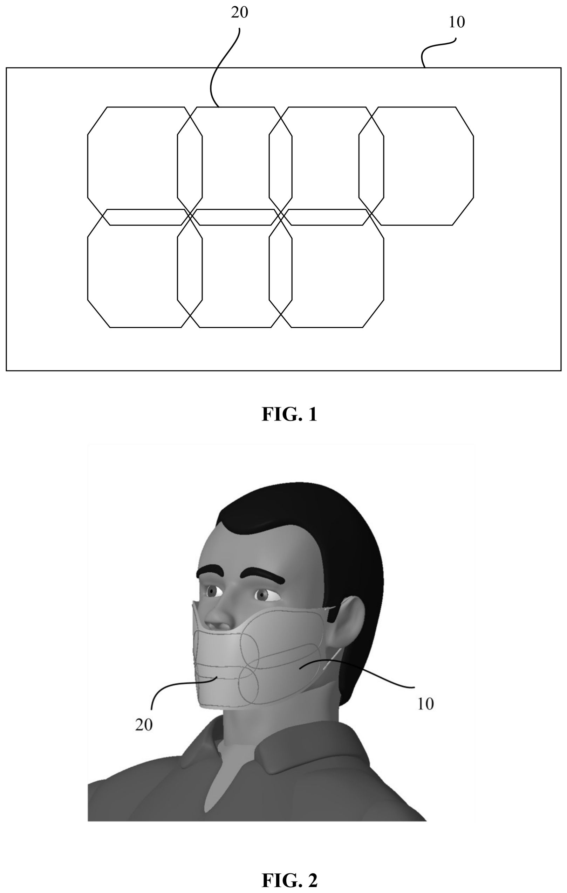

FIG. 1 is a schematic diagram illustrating an exemplary wireless coil according to some embodiments of the present disclosure.

As shown in FIG. 1, the wireless coil includes a flexible member 10 and one or more magnetic coupling units 20.

The flexible member 10 refers to a component that is capable of being bent or adapting to at least a portion of the body surface of a subject.

The subject may be at least a portion of a human body, a phantom, an animal body, etc., requiring an MRI examination. The subject includes the abdomen, the chest, the face, the head, a knee joint, an ankle, etc.

The one or more magnetic coupling units 20 are made of a high-performance material which is defined herein as a material with high electrical conductivity or superconducting properties, such as copper, silver, etc., or a superconducting material, to improve the transmission and reception efficiency of a radio frequency signal. For example, one of the one or more magnetic coupling units 20 may be a copper patch, which is low-cost, simple to manufacture, and may be bent.

In some embodiments, at least one of the one or more magnetic coupling units 20 may be a flexible coil. Using the flexible coil made of a flexible material as one of the one or more magnetic coupling units 20 can change the coverage area of the one or more magnetic coupling units 20 or bend according to a shape of an examination area, adapting to the needs of different subjects and improving wearing comfort. By changing the coverage area of the one or more magnetic coupling units 20, a B1 field in a specific region can be reshaped, allowing for flexible homogenization of the distribution of the B1 field according to imaging needs. Application scenarios for the wireless coil may include, but are not limited to, enhancing a focal field in the examination area, such as abdominal, dental, knee, and elbow, or even independent imaging. The flexible member 10 and the distribution of the one or more magnetic coupling units 20 on the flexible member 10 in the wireless coil support customized design.

In some embodiments, at least one of the one or more magnetic coupling units 20 isa wireless resonant coil, requiring no additional wired power supply or external equipment, thus avoiding the introduction of extra noise and workflow. With an overlapping decoupling design, no additional preamplifier decoupling circuit is needed, simplifying a circuit structure.

The wireless coil provided in some embodiments of the present disclosure, because it does not need to be attached to an original coil such as the transmitting coil of the MRI system, and a safe distance can be maintained between the wireless coil and the original coil, does not affect the coupling of the original coil itself.

In some embodiments, at least one of the one or more magnetic coupling units 20 may be an inductively coupled ring with a metamaterial. The inductively coupled ring resonates under the radio frequency field generated by the transmitting coil, generates a secondary field, and confines magnetic field lines in the coverage area, and focuses the B1 field in the coverage area, allowing the B1 field to penetrate deeper into an imaging object (i.e., the subject), thereby canceling internal dark bands. In some embodiments, two adjacent inductively coupled rings are decoupled by overlapping, ensuring that each inductively coupled ring operates at a frequency of the radio frequency field.

An inductively coupled ring has a wireless structure, which does not change the structure of the original coil, and does not add extra wiring, thereby simplifying coil design and reducing costs. An array including large-loop inductively coupled rings can not only ensure greater penetration depth but also, due to a lower Q value (i.e., a value of a quality factor) of the array of large-loop inductively coupled rings, avoid affecting the B1 field as much as possible, which is beneficial for a large FOV (field of view). The large-loop inductively coupled rings refer to magnetic coupling units with a relatively large physical diameter, such as resonant rings having a diameter in a range of 5 cm to 20 cm. After a pad carrying inductively coupled rings is placed in the examination area, the B1 field in the examination area is enhanced, improving overall uniformity and image quality.

In some embodiments, at least one of the one or more magnetic coupling units 20 is disposed on a surface of or inside the flexible member 10. For example, the one or more magnetic coupling units 20 are all disposed on the surface of or inside the flexible member 10. The wireless coil resonates in response to the radio frequency field generated by the transmitting coil of the MRI system, producing the focal field.

In the wireless coil provided in some embodiments of the present disclosure, based on a wireless resonance manner, the one or more magnetic coupling units 20 can be disposed inside the flexible member 10, facilitating cleaning and maintenance.

In some embodiments, the coverage area of the focal field is smaller than the coverage area of the radio frequency field.

The coverage area of the focal field refers to a spatial range effectively influenced by the focal field generated by the wireless coil. The coverage area of the radio frequency field refers to a spatial range effectively influenced by the radio frequency field.

Specifically, when the wireless coil is applied to the MRI system, the wireless coil is worn on the examination area of the subject based on the flexible member 10. The transmitting coil of the MRI system transmits the radio frequency field to the subject. The one or more magnetic coupling units 20 in the wireless coil resonate under the radio frequency field, generating an induced current, which in turn generates an induced magnetic field. The induced magnetic field is focused within the coverage area of the one or more magnetic coupling units 20, thereby producing the focal field. The coverage area of the focal field is smaller than the coverage area of the radio frequency field, thereby achieving reshaping of the B1 field in an area where the wireless coil is located (corresponding to the examination area). The characteristics of focal field focusing and coverage area differentiation can homogenize the magnetic field in the area where the wireless coil is located, suppress dark bands, and improve the imaging quality of the MRI system.

In some embodiments, as shown in FIG. 1, two adjacent magnetic coupling units 20 among the one or more magnetic coupling units partially overlap.

Wired coils typically use pre-amplifiers for decoupling. The wireless coil in the present disclosure directly removes the interference between the two adjacent magnetic coupling units through an overlapping of the one or more magnetic coupling units to achieve decoupling.

In some embodiments, as shown in FIG. 1, the one or more magnetic coupling units 20 have the same size, which simplifies design, improves the manufacturing efficiency of the one or more magnetic coupling units 20, and reduces manufacturing costs. When the one or more magnetic coupling units 20 have the same size, the diameter of one magnetic coupling unit 20 refers to the coil width of that magnetic coupling unit 20. The size of an overlapping area between the two adjacent magnetic coupling units 20 is 0.2-0.25 times the diameter of one magnetic coupling unit.

In some embodiments, the diameter of each magnetic coupling unit 20 among the one or more magnetic coupling units is in a range of 5 cm to 20 cm.

In some embodiments, the diameter of each magnetic coupling unit 20 may be set to 10 cm. The diameter of each magnetic coupling unit less than 5 cm may result in insufficient penetration depth, while the diameter of each magnetic coupling unit 20 exceeding 20 cm may weaken the ability to focus the magnetic field. Therefore, setting the diameter of each magnetic coupling unit 20 in the range of 5 cm to 20 cm can ensure that the penetration depth is sufficient to cover the dark bands in an original imaging result, effectively improving the dark band problem and enhancing the imaging quality.

The one or more magnetic coupling units 20 can be evenly distributed on the flexible member 10, and every two adjacent magnetic coupling units 20 partially overlap, ensuring a uniform distribution of the radio frequency field in an area where the one or more magnetic coupling units 20 are located, reducing the impact of the inhomogeneity of the radio frequency field on the imaging quality, and improving the imaging quality of magnetic resonance.

In some embodiments, the one or more magnetic coupling units 20 work independently. If one magnetic coupling unit 20 is damaged, it will not affect the other magnetic coupling units 20, improving the overall operational reliability of the wireless coil.

In some embodiments, the flexible member 10 is a wearable flexible member.

The wearable flexible member 10 refers to a wearable member that is capable of being worn on the subject, is flexible, and is capable of being deformed. For example, the wearable flexible member 10 may be a wearable member worn on the body surface areas (such as the abdomen, the chest, the face, the head, the knee joint, the ankle, etc.) of the subject. The shape of the wearable flexible member 10 matches the shape of the wearing area of the subject. The wearable flexible member 10 may be made of an insulating flexible material to avoid affecting the magnetic field of the MRI system and the one or more magnetic coupling units 20. For example, the wearable flexible member 10 may be made of a flexible skin-friendly material such as nylon cloth.

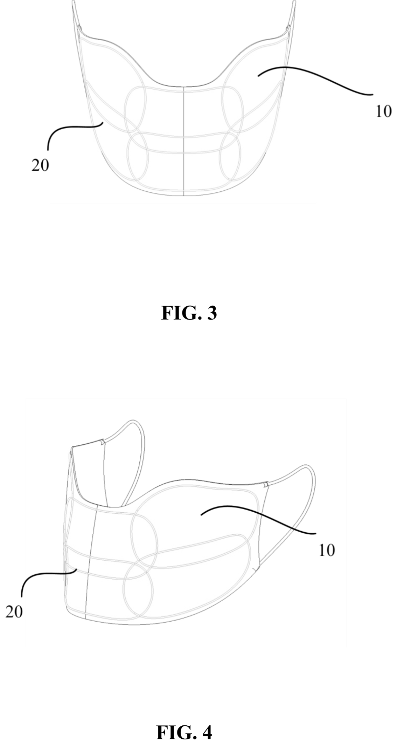

FIG. 2 is a schematic diagram illustrating a state where a wearable flexible member is worn on the face of a subject according to some embodiments of the present disclosure. FIG. 3 is a schematic diagram illustrating another exemplary wireless coil according to some embodiments of the present disclosure. FIG. 4 is a schematic diagram illustrating the wireless coil shown in FIG. 3 from another perspective.

As shown in FIGs. 2-4, a wireless coil includes a flexible member 10 and one or more magnetic coupling units 20. More descriptions for the flexible member 10 and the one or more magnetic coupling units 20 may be found elsewhere in the present disclosure.

For example, the flexible member 10 is a wearable flexible member 10. Further, the shape of the wearable flexible member 10 matches a facial contour of a subject to be scanned using an MRI system.

The wearable flexible member 10 may be made of a soft, comfortable, and harmless material, such as silicone, elastic fabric, or medical-grade polymer. This not only ensures the wearing comfort of the subject but also effectively fits the facial contours of different subjects. The shape of the wearable flexible member 10 matching the facial contour of the subject may be understood as closely fitting facial surface contour of the subject, including the chin, the cheek, and other areas. The matching of the wearable flexible member 10 with the facial contour of the subject can help reduce motion artifacts during imaging and improve imaging quality.

The wireless coil provided in some embodiments of the present disclosure combines the wearable flexible member 10 with the one or more magnetic coupling units 20. By designing the shape of the wearable flexible member 10 to match the subject's facial contour, it facilitates the subject's wearing.

In some embodiments, a side of the wearable flexible member 10 used for attaching to a body surface of the subject is provided with a replaceable layer. The replaceable layer may be made of a skin-friendly material. The skin-friendly material refers to a material that is non-irritating, non-toxic, hypoallergenic to human skin, and suitable for direct contact with the skin, such as medical-grade silicone, cotton fabric, or hydrocolloid dressings. When different subjects, the replaceable layer may be changed to prevent cross-infection. Optionally, the side of the wearable flexible member 10 used for attachment to the body surface of the subject may be made of a sterilizable material, such as one that does not chemically react with alcohol or disinfectants. This design can also help prevent cross-infection between subjects.

An oral region is also a complex imaging area, facing problems of uneven electromagnetic field distribution and poor imaging quality. In some embodiments, as shown in FIGs. 2-4, in a state where the wearable flexible member is worn on the face of the subject, the one or more magnetic coupling units 20 cover the oral region of the subject.

The shape of the wireless coil matches the facial contour of the subject and covers the oral region of the subject when worn. Utilizing a secondary field formed by the resonance of the one or more magnetic coupling units 20 under a radio frequency field can homogenize a B1 field in the oral region. A uniform radio frequency field helps improve a contrast, a resolution, and a signal-to-noise ratio of MRI, thereby enhancing the imaging quality of the oral region. This is of great significance for diagnosing oral diseases, evaluating oral structures, and planning oral surgeries.

In some embodiments, the distribution of the one or more magnetic coupling units 20 on the wearable flexible member 10 can provide personalized wireless coil customization services based on the facial contour of the subject and imaging needs. For example, a customized design can be performed based on factors such as an oral structure and tooth alignment of the subject to improve imaging quality and subject experience.

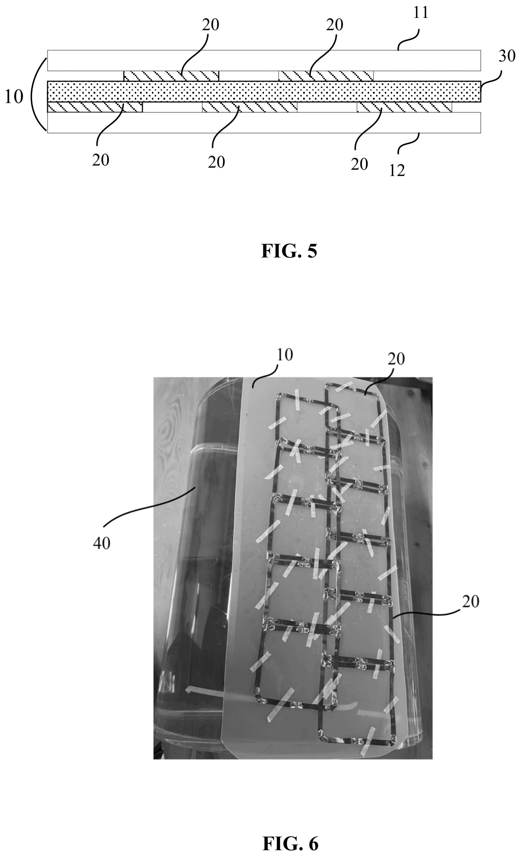

FIG. 5 is a schematic diagram illustrating a cross-sectional view of a wireless coil according to some embodiments of the present disclosure.

As shown in FIG. 5, a wireless coil includes a flexible member 10 and a plurality of magnetic coupling units 20. More descriptions for the flexible member 10 and the magnetic coupling units 20 may be found elsewhere in the present disclosure.

In some embodiments, as shown in FIG. 5, the wireless coil further includes an insulating spacer 30, and the insulating spacer 30 is disposed in an overlapping region of two adjacent magnetic coupling units 20 among the one or more magnetic coupling units 20.

The insulating spacer 30 refers to an insulating medium layer configured to prevent electrical shorts or arcing.

The insulating spacer 30 is made of a material with a high insulating property. The material with the high insulating property refers to a material with extremely high electrical resistivity and dielectric strength, enabling it to effectively prevent current flow and withstand high voltages without breakdown, such as Mylar (also known as polyester film or Polyethylene Terephthalate (PET) film). An electrical insulation property and a chemical stability of the material with the high insulation property enable the insulating spacer 30 to maintain stable performance in a high-frequency electromagnetic environment of an MRI system.

The insulating spacer 30 is disposed in the overlapping region of two adjacent magnetic coupling units 20 to prevent current leakage or short circuits in the overlapping region. Additionally, depending on the coil layout and imaging requirements, the insulating spacer 30 may also be extended to other critical parts of the wireless coil to further enhance electrical isolation.

In some embodiments, as shown in FIG. 5, the wearable flexible member 10 includes a first dielectric layer 11 and a second dielectric layer 12. The insulating spacer 30 is disposed between the first dielectric layer 11 and the second dielectric layer 12. A portion of the plurality of magnetic coupling units 20 are distributed between the first dielectric layer 11 and the insulating spacer 30, and another portion of the plurality of magnetic coupling units 20 are disposed between the second dielectric layer 12 and the insulating spacer 30. In this case, the overlapping arrangement of the two adjacent magnetic coupling units 20 may be understood as the projections of the two adjacent magnetic coupling units 20 on the same dielectric layer (the first dielectric layer or the second dielectric layer) partially overlapping. The overlapping arrangement of the two adjacent magnetic coupling units 20 simplifies the structure of the insulating spacer 30. In a manufacturing process, isolation between the two adjacent magnetic coupling units 20 can be achieved by directly laying the PET film or similar manner, which is beneficial for simplifying the manufacturing process and improving manufacturing efficiency.

In the present disclosure, by adjusting a layout, an overlap degree, and/or a current distribution of the one or more magnetic coupling units 20, a uniformity of a radio frequency field generated by a transmitting coil of the MRI system can be further optimized. The wireless coil provided in some embodiments of the present disclosure can perform real-time reshaping according to an inhomogeneity characteristic of the B1 field. For example, by changing the coverage area and a spacing distance of the one or more magnetic coupling units 20, weakening the over-flipping area, or enhancing imaging areas with weaker magnetic fields.

In an application scenario of 5T abdominal imaging, the wireless coil provided in some embodiments of the present disclosure has an obvious mitigating effect on artifacts caused by standing waves. The wireless coil provided in some embodiments of the present disclosure may also be used as a dental coil for oral imaging, for example, when the transmitting coil (e.g., Volume Transmit Coil (VTC)) of the MRI system is transmitting and receiving signals; a wired joint receive coil, such as a knee coil, an ankle coil, etc., for knee and ankle imaging.

In some embodiments, taking the one or more magnetic coupling units as resonant rings as an example, a reverse transmission coefficient S₁₂ of an overlapping region of two adjacent resonant rings is given by the following formula (1): ${S}_{12} = \frac{2 {RZ}_{12}}{4 {R}^{2} - {{Z}_{12}}^{2}} = \frac{{Z}_{12}}{2 R} = \frac{{iωL}_{12} + {R}_{12}}{2 R} = \frac{{iωK}_{m} L + {R}_{12}}{2 R} = \frac{1}{2} \left({iK}_{m}Q+{K}_{e}\right) ,$ where S₁₂ is the reverse transmission coefficient, characterizing an efficiency of energy transmission from one resonant ring (a resonant ring 2) to another adjacent resonant ring (a resonant ring 1); i is an imaginary unit; K_{c} is an electric coupling coefficient, and K_{c}=R₁₂/R, wherein R is a total circuit loss of the wireless coil, and R₁₂ is a circuit loss between the two adjacent resonant rings (the resonant ring 1 and the resonant ring 2). An overlapping area of the two adjacent resonant rings affects the circuit loss R₁₂ between the two adjacent resonant rings. The change in the overlapping area alters R₁₂, thereby affecting the electric coupling coefficient K_{c}. Through experimental testing, when all the resonant rings have the same size and a width of the overlapping region of two adjacent resonant rings shown in FIG. 5 is 0.2-0.25 times a diameter of one resonant ring (i.e., a distance between a left side and a right side of one resonant ring), K_{c} is 0, meaning the coupling between the two adjacent resonant rings is minimal.

Kₘ is a magnetic coupling coefficient, and Kₘ=L₁₂/L; Q is a quality factor, and Q=ωL₁₂/R. L is a spatial periodicity, and L₁₂ is a mutual inductance strength between the two adjacent resonant rings. Z₁₂ is a coupling impedance between the two adjacent resonant rings. The magnetic coupling coefficient Kₘ increases as the mutual inductance strength between the two adjacent resonant rings increases. The change in the overlapping area of the two adjacent resonant rings directly affects the mutual inductance strength L₁₂ between the two adjacent resonant rings. By adjusting the overlapping area of the two adjacent resonant rings, the mutual inductance strength between the two adjacent resonant rings may be changed. By making L₁₂ and S12 tend towards 0, the two adjacent resonant rings achieve overlapping decoupling.

The resonance of the one or more magnetic coupling units 20 under the radio frequency field generated by the transmitting coil may be achieved by adjusting an equivalent capacitance value of the one or more magnetic coupling units 20. Taking the one or more magnetic coupling units 20 as an example of coils for illustration, each coil is equivalent to an RLC series circuit. The coil itself is an inductor (copper skin) with an inductive reactance X_{L}. A loading capacitor in the coil has a capacitive reactance X_{C}. An impedance |Z| of the equivalent RLC series circuit of the coil is denoted by formular (2) as following: $\left|Z\right| = \sqrt{{R}_{2} + \left({{X}_{L}}^{2}-{{X}_{C}}^{2}\right)} ,$ where R₂ is a resistance of the coil.

When the coil is at a resonant frequency, X_{L}=X_{C}. The resonant frequency is the same as the frequency of the radio frequency field generated by the transmitting coil. The reactance (X_{L}² - X_{C}²) of the coil is zero, and the impedance |Z| is minimum. At this time, a voltage across the coil increases, a circuit current increases significantly, and the magnetic field strength around the coil increases, greatly enhancing the magnetic flux within the coil, achieving the purpose of enhancing a local magnetic field strength. Therefore, by changing the equivalent capacitance value of the coil to tune the resonant frequency of the coil to an operating frequency of the radio frequency field generated by the transmitting coil, the magnetic field of the radio frequency field may be locally optimized.

FIG. 6 is a schematic diagram illustrating a wireless coil during a water phantom test according to some embodiments of the present disclosure.

As shown in FIG. 6, a wireless coil is used in the water phantom test. The wireless coil includes a flexible member 10 and a plurality of magnetic coupling units 20. More descriptions for the flexible member 10 and the magnetic coupling units 20 may be found elsewhere in the present disclosure. The wireless coil covers the water phantom during the water phantom test.

As shown in FIG. 6, two adjacent magnetic coupling units 20 among the one or more magnetic coupling units partially overlap, and a diameter of each magnetic coupling unit 20 among the one or more magnetic coupling units is in a range of 5 cm to 20 cm. The one or more magnetic coupling units 20 are set to have the same size. After conducting a magnetic resonance water phantom test under a structure shown in FIG. 6 (placing the wireless coil covering a water phantom 40 and testing under a radio frequency field excited by an MRI system), it was found that when a width of an overlapping region between the two adjacent magnetic coupling units 20 accounts for 0.2-0.25 times the diameter of one magnetic coupling unit 20, dark bands may be effectively suppressed, improving the imaging quality of magnetic resonance. When the width of the overlapping region between the two adjacent magnetic coupling units 20 accounts for 0.2 times the diameter of one magnetic coupling unit 20, the imaging quality is even better.

The diameter of the one magnetic coupling unit 20 is positively correlated with a depth of the dark bands from a surface of the water phantom in an original imaging result (i.e., an imaging result of the MRI system without using the wireless coil). The deeper the dark bands in the original imaging result, the larger the required area of the one magnetic coupling unit 20. Taking the one or more magnetic coupling units 20 as inductively coupled rings as an example, an effective penetration depth of each inductively coupled ring is approximately equal to $\sqrt{2}$ times a diameter of the each inductively coupled ring. The deeper the depth of the dark bands, the larger a required diameter of the each inductively coupled ring. Exemplarily, for a situation where the dark bands are at a depth of 12-13 cm from the surface of the water phantom, one or more magnetic coupling units 20 with a diameter of 16 cm can be selected to ensure that the effective penetration depth of the one or more magnetic coupling units 20 is sufficient to cover the position of the dark bands in the original imaging result, thereby effectively improving a dark band problem and enhancing imaging quality.

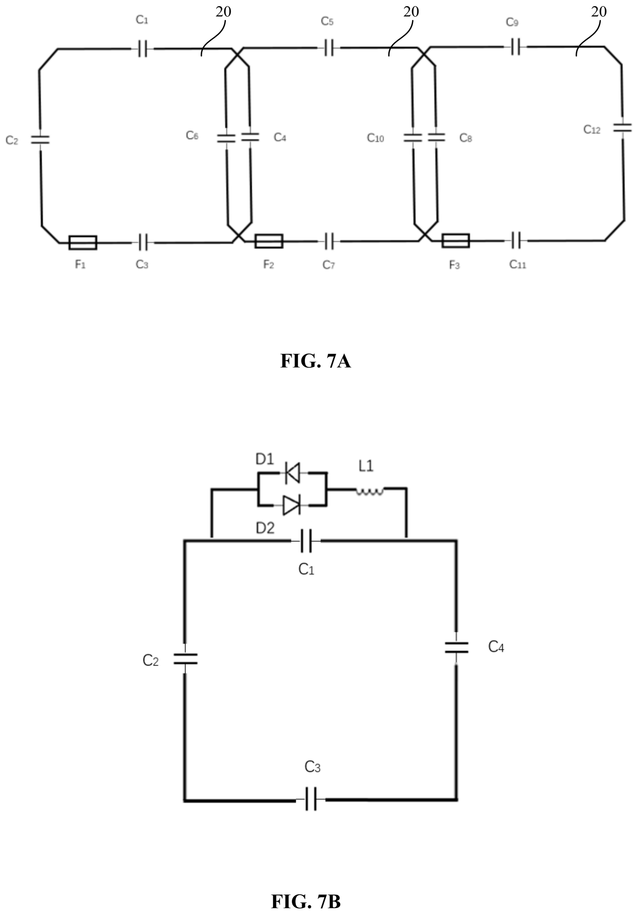

FIG. 7A is a schematic diagram illustrating one or more tuning elements and a protection device according to some embodiments of the present disclosure.

In some embodiments, each of the one or more magnetic coupling units 20 is further provided with one or more tuning elements, and the one or more tuning elements enable each of the one or more magnetic coupling units 20 to resonate at a frequency of a radio frequency field generated by a transmitting coil.

A tuning element refers to an electronic component connected in a resonant circuit for adjusting the resonant frequency of the resonant circuit.

The one or more tuning elements may be implemented using capacitors, inductors, resistors, or combinations thereof. As shown in FIG. 7A, the one or more tuning elements on the each of the one or more magnetic coupling units 20 may include a plurality of tuning capacitors (such as C1, C2, C3, ..., C12 in FIG. 7A) connected in series on the each of the one or more magnetic coupling units 20 to adjust the resonant frequency of the each of the one or more magnetic coupling units 20, thereby enabling the each of the one or more magnetic coupling units 20 to couple with the radio frequency field generated by the transmitting coil, forming a secondary field to reshape the B1 field. The capacitance of tuning capacitor C1 to tuning capacitor C12 is from 2.7pF to 5.6pF.

In some embodiments, the one or more tuning elements of one of the one or more magnetic coupling units are uniformly arranged along the one of the one or more magnetic coupling units 20.

As shown in FIG. 7A, a plurality of tuning elements (i.e., tuning capacitors C1, C2, C3, ..., C12) may be disposed on sides of the each of the one or more magnetic coupling units 20 at equal intervals to improve the uniformity of the radio frequency field.

In some embodiments, the count of the one or more tuning elements is even.

In some embodiments, the each of the one or more magnetic coupling units 20 is set as a rectangle, so having an even count of the one or more tuning elements is more convenient for uniform arrangement.

In some embodiments, the one or more magnetic coupling units 20 are inductively coupled rings with a metamaterial in periodic structure, and each inductively coupled ring is provided with 4 tuning capacitors to ensure a value of Q (i.e., the value of the quality factor) of the one or more magnetic coupling units 20.

In some embodiments, the bandwidth of the one or more magnetic coupling units 20 may cover 190 MHz to 220 MHz. Under loaded conditions, the bandwidth range of 190 MHz to 220 MHz may accommodate frequency deviations caused by most load variations (e.g., different dielectric constants of different subjects), ensuring that the wireless coil resonates effectively on the different subjects.

In some embodiments, each of the one or more magnetic coupling units 20 is further provided with a protection device, and the protection device is configured to control the each of the one or more magnetic coupling units 20 to detune when an induced current on the each of the one or more magnetic coupling units 20 exceeds a preset current range.

The protection device refers to an element connected in series in a circuit, configured to cut off the circuit or change its state under an abnormal condition (such as overcurrent, overheating) to prevent damage or safety incidents.

The preset current range may be determined based on the safe operating requirements of the wireless coil. For example, an upper limit of the preset current range may be set based on an upper temperature limit during operation of the wireless coil to avoid burning the subject's skin. As another example, the upper limit of the preset current range may be set as a maximum current allowed by the one or more tuning elements to avoid damaging components.

By providing the protection device, damage to the one or more tuning elements can be avoided, and overheating of the wireless coil can also be prevented, thereby ensuring the stability and reliability of the operation of the one or more magnetic coupling units 20, and improving imaging quality and subject experience.

In some embodiments, the protection device includes a fuse. As shown in FIG. 7A, each of the one or more magnetic coupling units 20 may be provided with one fuse (such as F1, F2, and F3 in FIG. 7A). When a current is too high causing a temperature to rise (i.e., the induced current exceeding the preset current range causes a temperature of one magnetic coupling unit 20 exceeding a set threshold), the fuse on the magnetic coupling unit 20 whose temperature exceeds the set threshold has blown, physically cutting off a loop formed by the magnetic coupling unit 20, causing the wireless coil to switch from a resonant state to a detuned state, achieving protection.

The resonant state refers to a state where the one or more magnetic coupling units 20 resonate under the radio frequency field to focus energy and generate the focal field.

The detuned state refers to a safe, silent state where the one or more magnetic coupling units 20 are unable to generate the focal field and are considered "failed".

FIG. 7B is a schematic diagram illustrating a structure of a detuned circuit according to some embodiments of the present disclosure.
As shown in FIG. 7B, the detuned circuit includes two diodes (D1 and D2) and an inductor (L1), wherein the two diodes are connected in reverse parallel and coupled in series with the inductor to the resonant circuit of the magnetic coupling unit. When the transmitting coil emits a radio frequency field, the induced voltage on the magnetic coupling unit turns on the two diodes, thereby connecting the inductor into the resonant circuit, changing the resonant frequency of the circuit, and switching the magnetic coupling unit from a resonant state to a detuned state. The capacitance of tuning capacitor C1 to tuning capacitor C4 is from 2.7pF to 5.6pF; the inductance of the inductor L1 is from 82uH to 120uH.

In some embodiments, the wireless coil further includes an external interface, and the external interface is configured to enable the protection device to control each of the one or more magnetic coupling units 20 to detune in a wired connection manner.

The external interface is configured to introduce an external control signal. Through the wired connection manner, an external controller may be connected to each of the one or more magnetic coupling units 20 via the external interface to transmit the external control signal to actively control the detuning of the each of the one or more magnetic coupling units 20. The physical form of the external interface may be an electrical interface (such as a LEMO connector or a Universal Serial Bus (USB)-type interface), an optical interface (such as a fiber optic connector), etc. Exemplarily, the protection device may include an active component (such as a P-type, Intrinsic, N-type (PIN) diode). During normal operation, the external interface is not powered, and the PIN diode is in a cut-off state, not affecting the resonance of the one or more magnetic coupling units. When detuning is required, a direct current is applied through the external interface, and the direct current is transmitted to the PIN diode on the one or more magnetic coupling units via the wired connection manner (such as a cable), thereby turning on the PIN diode. The conduction of the PIN diode changes the capacitance or the inductance of the resonant circuit, causing the resonant circuit to deviate from an original resonant frequency of the resonant circuit, thereby forcing detuning.

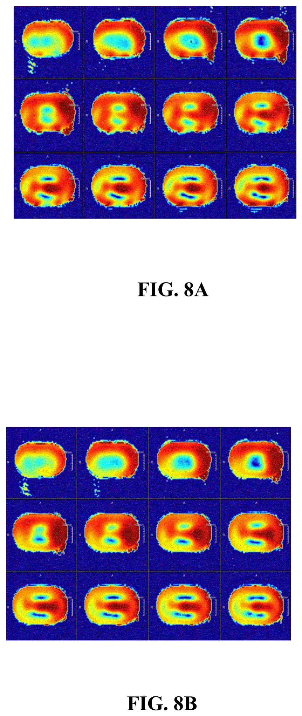

FIG. 8A is an image of a B1 field result when a transmitting coil performs radio frequency signal transmission and reception without using a wireless coil. FIG. 8B is an image of a B1 field result when a transmitting coil performs radio frequency signal transmission and reception with an application of a wireless coil.

The B1 field result image refers to an image reflecting the spatial distribution of the B1 field (i.e., the radio frequency field) intensity. Such an image is typically obtained through specific magnetic resonance scanning sequences (e.g., B1 mapping sequences) and presented in the form of a heat map, where different colors or brightness levels represent the uniformity of the B1 field. Higher brightness in the image indicates a stronger B1 field, while lower brightness indicates a weaker B1 field. By comparing the result images in FIG. 8A and FIG. 8B, the change in B1 field uniformity before and after application of the wireless coil can be intuitively assessed.

In some embodiments, according to result images (i.e., heat maps) of the B1 field during radio frequency signal transmission and reception performed by the transmitting coil shown in FIGs. 8A and 8B, a brightness distribution of the result image in FIG. 8b is more uniform, a color gradient variation is smoother, and there are no obvious dark bands, indicating that the uniformity of the B1 field is enhanced when the wireless coil is applied, compared to when the wireless coil is not used.

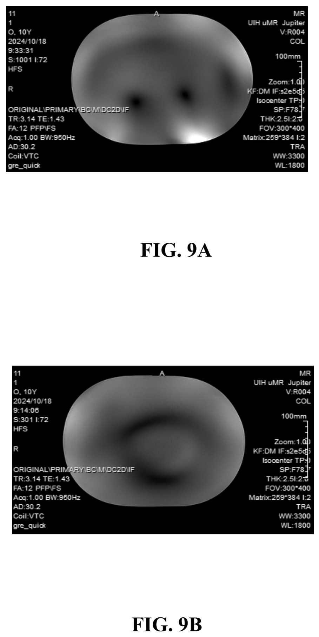

FIG. 9A is a result image of a GRE_quick sequence without using a wireless coil. FIG. 9B is a result image of a GRE_quick sequence with an application of a wireless coil.

The result image of the GRE_quick sequence refers to a magnetic resonance image reconstructed after scanning with the GRE_quick sequence. The result image is presented in grayscale, where different grayscale values represent signal intensities at different positions within the imaging region. The GRE_quick sequence is particularly sensitive to the uniformity of a B1 field-when the B1 field is uniform, the image grayscale distribution is consistent and smooth; when the B1 field is non-uniform, the result image will directly show obvious brightness changes or dark bands. Therefore, the result images of the GRE_quick sequence shown in FIGs. 9A and 9B are used to visually assess the improvement in the uniformity of the B1 field before and after application of the wireless coil.

In some embodiments, according to the result images of the GRE_quick sequence shown in FIGs. 9A and 9B, the image grayscale in FIG. 9B is more consistent and smoother, indicating that the quality of the result image from the GRE_quick sequence with the wireless coil is effectively improved compared to the GRE_quick sequence without the wireless coil.

The GRE_quick sequence (gradient-recalled echo quick sequence) is a fast gradient echo sequence, which is particularly sensitive to magnetic field inhomogeneity. If the magnetic field is not uniform, the result image of the GRE_quick sequence will directly show obvious brightness changes or dark bands.

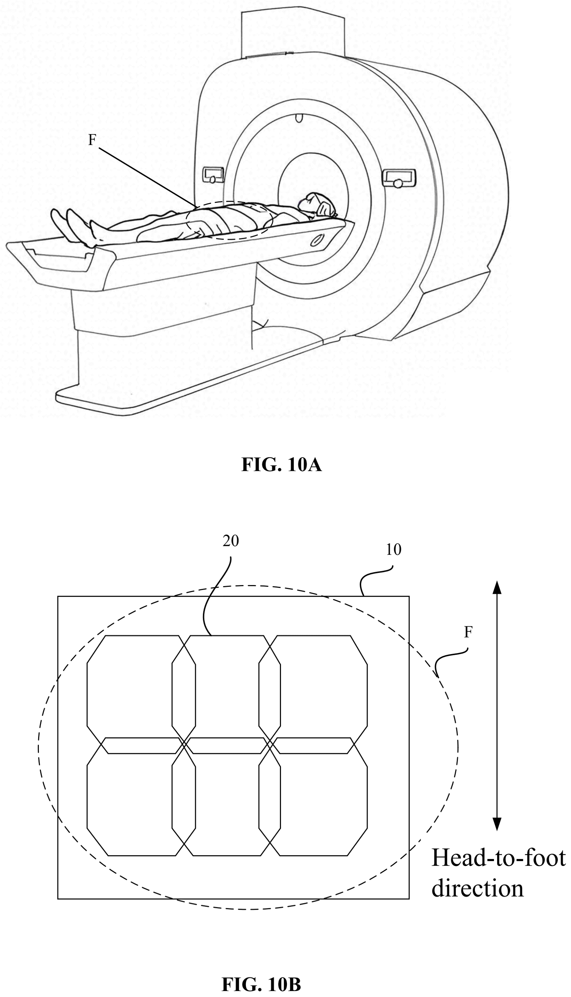

FIG. 10A is a schematic diagram illustrating a subject entering an MRI system along a head-to-foot direction according to some embodiments of the present disclosure. FIG. 10B is a schematic diagram illustrating an arrangement of one or more magnetic coupling units in a wireless coil along a head-to-foot direction of a subject according to some embodiments of the present disclosure.

The head-to-foot direction refers to an axis along the subject's longitudinal axis, running from the head to the feet. In the MRI system, the head-to-foot direction is typically aligned with the patient table movement and the main magnetic field (Z-axis) direction.

In some embodiments, as shown in FIGs. 10A and 10B, the flexible member 10 covers an abdomen F of the subject to be scanned using the MRI system as described elsewhere in the present disclosure, the one or more magnetic coupling units 20 are arranged in two rows along the head-to-foot direction of the subject, and each of the two rows includes three magnetic coupling units 20 arranged adjacent to each other from left to right.

By arranging the one or more magnetic coupling units 20 in two rows along the head-to-foot direction of the subject, decoupling through the overlap of the front and rear rows of magnetic coupling units 20 may be achieved, enabling reshaping of the B1 field of the abdomen F and improving imaging quality of the abdomen F. At the same time, by arranging at least three magnetic coupling units 20 in a left-right direction, it can ensure B1 field reshaping in the left-right direction, improving imaging quality, and ensure full coverage of the abdomen F, increasing the imaging range. With the above arrangement of the one or more magnetic coupling units 20, high-quality imaging results of an entire area of the abdomen F can be provided.

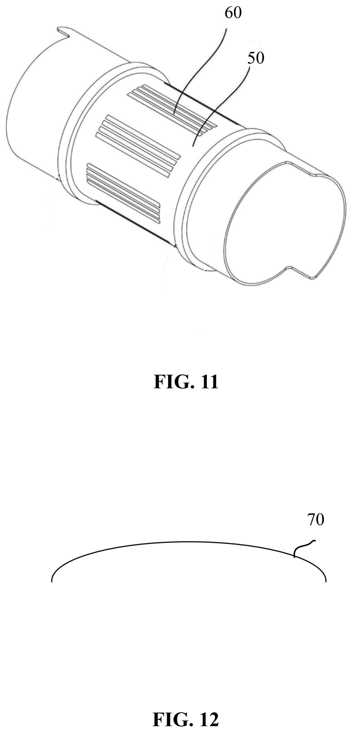

FIG. 11 is a schematic diagram illustrating an MRI system according to some embodiments of the present disclosure.

In some embodiments, as shown in FIG. 11, an MRI system 100 includes a support cylinder 50, a transmitting coil 60, a flexible member 70 (not shown in FIG. 11), and one or more magnetic coupling units 20 (not shown in FIG. 11). The flexible member 70 and the one or more magnetic coupling units 20 are not shown in FIG. 11, and detailed descriptions thereof may be found in FIGs. 1-4.

The support cylinder 50 provides an accommodation cavity, and the accommodation cavity is configured to accommodate a subject. The transmitting coil 60 is disposed on the support cylinder 50 and located on the outer surface of the support cylinder 50, for generating a radio frequency field, so that nuclear spins within the body of the subject are excited to generate magnetic resonance signals. The transmitting coil 60 may be in various forms, such as a birdcage coil, a quadrature coil, a saddle coil, etc.

The flexible member 70 is capable of covering at least a portion (e.g., an organ or tissue) of the subject. The one or more magnetic coupling units 20 are disposed on the flexible member 70, and the one or more magnetic coupling units 20 are capable of resonating under the radio frequency field to produce a focal field.

More descriptions of the one or more magnetic coupling units 20 resonating under the radio frequency field to produce the focal field, may be found elsewhere in the present disclosure.

In some embodiments, the transmitting coil 60 may also be configured to receive magnetic resonance signals, integrating transmission and reception to achieve a compact design of the MRI system 100 and reduce hardware costs.

In some embodiments, a detector may be disposed on an inner side of the support cylinder 50, and the detector is located between the support cylinder 50 and the transmitting coil 60. The detector is configured to receive gamma photons generated by radio nuclides within the body of the subject. After the detector receives the gamma photons generated by the radio nuclides within the body of the subject, the detector converts an optical signal (i.e., the gamma photons) into an electrical signal associated with gamma photon counts. A working module of the MRI system 100 performs image reconstruction through a Positron Emission Tomography (PET) reconstruction algorithm based on the electrical signal, thereby obtaining a PET image. Additionally, the support cylinder 50 may be made of an insulating material, such as fiberglass.

The working module includes a signal processing and calculation unit connected with the detector in a nuclear MRI system (e.g., a PET imaging system). The working module may include an analog circuit (e.g., an amplifier and a filter), an analog-to-digital converter (ADC), and a digital processor. The digital processor may include a field-programmable gate array (FPGA), a digital signal processor (DSP), a central processing unit (CPU), a graphics processing unit (GPU), etc.

The MRI system 100 utilizes the one or more magnetic coupling units 20 to homogenize a B1 field. Without affecting original coils such as the transmitting coil 60, the one or more magnetic coupling units 20 can homogenize the B1 field, ensuring that the nuclear spins of the organs or tissue of the subject can be effectively excited to generate the magnetic resonance signals, thereby improving imaging quality. Furthermore, by achieving decoupling through the overlap of the one or more magnetic coupling units 20, no additional decoupling circuit is required, simplifying the structure of the wireless coil.

In some embodiments, the support cylinder 50 is a cylindrical tube.

FIG. 12 is a schematic diagram illustrating a flexible member according to some embodiments of the present disclosure.

In some embodiments, the flexible member is configured to adhere to at least one of the abdomen, the chest, or the face of the subject, or the flexible member is configured to wrap at least one of the head, a knee joint, or an ankle of the subject. For example, the flexible member 70 may be arc-shaped and attached to the abdomen of the subject, as shown in FIG. 12.

The flexible member 70 may be attached to a body surface area corresponding to the organ or tissue of the subject. For example, the flexible member 70 directly covers the body surface area, such as the abdomen, the chest, or the face of the subject based on gravity. A specific manner of attachment is not limited, such as covering or adhering based on an adhesive substance.

In some embodiments, the flexible member 70 may be worn to wrap around the body surface area corresponding to the organ or tissue of the subject. For example, the flexible member 70 may be a wearable flexible member as described in the present disclosures. Based on wearable characteristics, the wearable flexible member may be accurately worn on parts with complex external surface structures and prone to displacement, such as the head, the knee joint, and the ankle of the subject, ensuring that the one or more magnetic coupling units 20 carried by the flexible member 70 are tightly attached to the parts of the subject during an examination and imaging process, guaranteeing imaging quality.

In some embodiments, each of the one or more magnetic coupling units 20 is further provided with a protection device, and the protection device is configured to control the each of the one or more magnetic coupling units 20 to switch from a resonant state to a detuned state when a temperature of the each of the one or more magnetic coupling units 20 exceeds a set threshold. For a specific process of achieving detuning, reference may be made to the description in the above embodiments (such as the relevant embodiment in FIG. 7A), which will not be repeated here.

The protection device may be a device such as a fuse. By providing the fuse, based on an over-temperature fusing characteristic of the fuse, when a temperature of one magnetic coupling unit 20 exceeds a set threshold due to overcurrent, overvoltage, short circuit, etc., the fuse blows, cutting off a power supply path on the one magnetic coupling unit 20. The one magnetic coupling unit 20 fails and switches from the resonant state to the detuned state, thereby achieving protection for the one magnetic coupling unit 20. The set threshold may be an operating temperature corresponding to a maximum current allowed by one or more tuning elements on the one magnetic coupling unit 20. More descriptions of the one or more tuning elements may be found elsewhere in the present disclosure (such as the relevant embodiment in FIG. 7A), which will not be repeated here.

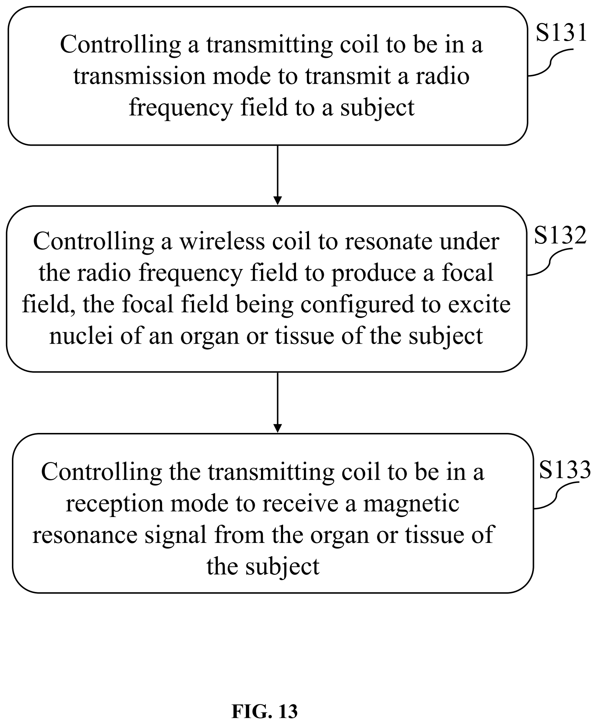

FIG. 13 is a flowchart illustrating an exemplary process of a control method for an MRI system according to some embodiments of the present disclosure.

In some embodiments, an MRI system includes a transmitting coil and a wireless coil, the transmitting coil and the wireless coil are disposed separately from each other, and the wireless coil is capable of covering at least a portion of a subject. As shown in FIG. 13, the control method for the MRI system includes the following operations S131-S133. In some embodiments, the control method for the MRI system may be executed by a working module of the MRI system, such as by a processor.

In S131, a transmitting coil of the MRI system may be controlled to be in a transmission mode to transmit a radio frequency field to a subject.

When the transmitting coil is in the transmission mode, the transmitting coil transmits the radio frequency field to the subject, which may excite nuclear spins within the body of the subject, thereby generating a magnetic resonance signal.

In S132, a wireless coil of the MRI system may be controlled to resonate under the radio frequency field to produce a focal field. The focal field may be configured to excite nuclei of an organ or tissue of the subject.

The wireless coil resonates under the excitation of the radio frequency field, generating an induced current in the wireless coil. The induced current generates an induced magnetic field, which is focused within the coverage area of the one or more magnetic coupling units to form the focal field. Therefore, the wireless coil in a resonant state affects a distribution of the radio frequency field provided by the transmitting coil, causing a B1 field (i.e., the radio frequency field) in an area where the wireless coil is located to be reshaped and become more uniform, ensuring an excitation effect of the B1 field on an examination area of the subject and obtaining high-quality magnetic resonance signals.

In S133, the transmitting coil may be controlled to be in a reception mode to receive a magnetic resonance signal from at least a portion (e.g., the organ or tissue) of the subject.

By using the transmitting coil as the receiving coil to receive the magnetic resonance signal excited after B1 field reshaping, the quality of a magnetic resonance image generated based on the magnetic resonance signal is high. Furthermore, by controlling the transmitting coil to switch between the transmission mode and the receive mode, multiplexing of the transmitting coil is achieved, which can simplify the hardware structure and reduce costs.

In some embodiments, the switching between the transmission mode and the receive mode of the transmitting coil may be achieved through periodic switching, timed switching, etc. In some embodiments, a duration for which the transmitting coil is in the transmission mode may be greater than a duration for which the transmitting coil is in the receive mode, so that the transmitting coil excites the magnetic resonance signal more effectively.

In some embodiments, the transmitting coil may be a transmitting coil distributed on the MRI system or a local transmitting coil, such as a volume transmitting coil.

In some embodiments, the wireless coil includes one or more magnetic coupling units, and the one or more magnetic coupling units are distributed in rows and columns to form an array structure. The wireless coil is configured to adhere to at least one of the abdomen, the chest, or the face of the subject, or the wireless coil is configured to wrap at least one of the head, a knee joint, or an ankle of the subject.

By arranging the one or more magnetic coupling units 20 in an array, it can effectively cover the organ or tissue of the subject in both row and column directions, allowing the wireless coil to conform in shape to at least one of the abdomen, the chest, or the face of the subject, or at least one of the head, the knee joint, or the ankle of the subject, thereby achieving B1 field reshaping for these examination areas.

By arranging the one or more magnetic coupling units 20 in the array, while meeting attachment requirements for different areas, the volume of a single magnetic coupling unit 20 may be reduced, decreasing the frequency of large-angle bending of the one or more magnetic coupling units 20 and increasing the service life of the wireless coil. Additionally, a miniaturized volume of the single magnetic coupling unit 20 is more conducive to conforming to the surfaces of protruding parts, such as the knee joint and the head, thereby ensuring the B1 field reshaping effect and improving the quality of MRI.

In some embodiments, the processor may control each of the one or more magnetic coupling units 20 to detune via a protection device of the each of the one or more magnetic coupling units 20.

More descriptions of the protection device may be found in FIG. 7A.

In some embodiments, the processor may enable the protection device to control the each of the one or more magnetic coupling units 20 to detune in a wired connection manner via an external interface provided on the wireless coil.

More descriptions of the external interface may be found elsewhere in the present disclosure.

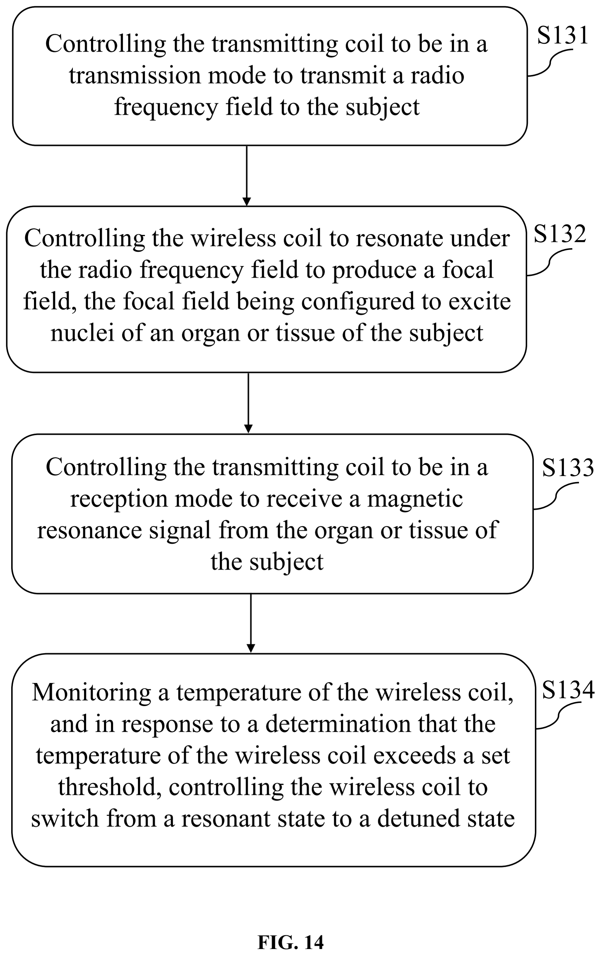

FIG. 14 is a flowchart illustrating another exemplary process of a control method for an MRI system according to some embodiments of the present disclosure.

In some embodiments, as shown in FIG. 14, the control method for the MRI system further includes the following operation S134.

In S134, a temperature of the wireless coil may be monitored, and in response to a determination that the temperature of the wireless coil exceeds a set threshold, the wireless coil is controlled to switch from a resonant state to a detuned state.

The temperature of the wireless coil may be monitored by providing a temperature sensor. The temperature of the wireless coil may also be characterized by the temperature of the one or more magnetic coupling units 20. Monitoring the temperature of the one or more magnetic coupling units 20, besides using the temperature sensor, may also be achieved by collecting the resistance of the one or more magnetic coupling units 20. As the temperature rises, the resistance of the one or more magnetic coupling units 20 also increases. Therefore, based on a collection result of the resistance of the one or more magnetic coupling units 20, the temperature of the one or more magnetic coupling units may be determined, thereby understanding the temperature at various positions within the wireless coil.

By monitoring the temperature of the wireless coil, if the temperature exceeds the set threshold, it indicates a possible situation of burning the subject or damaging the wireless coil. At this point, controlling the wireless coil to switch from the resonant state to the detuned state means no current flows through the wireless coil, and the temperature of the wireless coil decreases, helping prevent burning the subject. Furthermore, because there is no current flow, further damage to the components of the wireless coil can be avoided, increasing its service life. By controlling the one or more magnetic coupling units to switch from the resonant state to the detuned state, the wireless coil may be switched from the resonant state to the detuned state.

Having thus described the basic concepts, it may be rather apparent to those skilled in the art after reading this detailed disclosure that the foregoing detailed disclosure is intended to be presented by way of example only and is not limiting. Although not explicitly stated here, those skilled in the art may make various modifications, improvements, and amendments to the present disclosure. These alterations, improvements, and modifications are intended to be suggested by this disclosure and are within the spirit and scope of the exemplary embodiments of this disclosure.

Moreover, certain terminology has been configured to describe embodiments of the present disclosure. For example, the terms "one embodiment," "an embodiment," and/or "some embodiments" mean that a particular feature, structure, or feature described in connection with the embodiment is included in at least one embodiment of the present disclosure. Therefore, it is emphasized and should be appreciated that two or more references to "an embodiment" or "one embodiment" or "an alternative embodiment" in various portions of the present disclosure are not necessarily all referring to the same embodiment. In addition, some features, structures, or characteristics of one or more embodiments in the present disclosure may be properly combined.

Furthermore, the recited order of processing elements or sequences, or the use of numbers, letters, or other designations, therefore, is not intended to limit the claimed processes and methods to any order except as may be specified in the claims. Although the above disclosure discusses some embodiments of the invention currently considered useful by various examples, it should be understood that such details are for illustrative purposes only, and the additional claims are not limited to the disclosed embodiments. Instead, the claims are intended to cover all combinations of corrections and equivalents consistent with the substance and scope of the embodiments of the invention. For example, although the implementation of various components described above may be embodied in a hardware device, it may also be implemented as a software only solution, e.g., an installation on an existing server or mobile device.

Similarly, it should be appreciated that in the foregoing description of embodiments of the present disclosure, various features are sometimes grouped together in a single embodiment, figure, or description thereof for the purpose of streamlining the disclosure aiding in the understanding of one or more of the various embodiments. However, this disclosure does not mean that object of the present disclosure requires more features than the features mentioned in the claims. Rather, claimed subject matter may lie in less than all features of a single foregoing disclosed embodiment.

In some embodiments, the numbers expressing quantities or properties configured to describe and claim certain embodiments of the present disclosure are to be understood as being modified in some instances by the term "about," "approximate," or "substantially." For example, "about," "approximate," or "substantially" may indicate ±20% variation of the value it describes, unless otherwise stated. Accordingly, in some embodiments, the numerical parameters set forth in the written description and attached claims are approximations that may vary depending upon the desired properties sought to be obtained by a particular embodiment. In some embodiments, the numerical parameters should be construed in light of the number of reported significant digits and by applying ordinary rounding techniques. Notwithstanding that the numerical ranges and parameters setting forth the broad scope of some embodiments of the present disclosure are approximations, the numerical values set forth in the specific examples are reported as precisely as practicable.

Each of the patents, patent applications, publications of patent applications, and other material, such as articles, books, specifications, publications, documents, things, and/or the like, referenced herein is hereby incorporated herein by this reference in its entirety for all purposes. History application documents that are inconsistent or conflictive with the contents of the present disclosure are excluded, as well as documents (currently or subsequently appended to the present disclosure) limiting the broadest scope of the claims of the present disclosure. By way of example, should there be any inconsistency or conflict between the description, definition, and/or the use of a term associated with any of the incorporated material and that associated with the present document, the description, definition, and/or the use of the term in the present document shall prevail.

In closing, it is to be understood that the embodiments of the present disclosure disclosed herein are illustrative of the principles of the embodiments of the present disclosure. Other modifications that may be employed may be within the scope of the present disclosure. Thus, by way of example, but not of limitation, alternative configurations of the embodiments of the present disclosure may be utilized in accordance with the teachings herein. Accordingly, embodiments of the present disclosure are not limited to that precisely as shown and described.

## Claims

1. A wireless coil applied to a magnetic resonance imaging system, the magnetic resonance imaging system includes a transmitting coil having a housing cavity, the wireless coil comprising:
a flexible member (10); and
one or more magnetic coupling units (20), disposed on a surface of or inside the flexible member (10); wherein
the wireless coil and the transmitting coil are respectively separated from each other in a radial direction of the housing cavity; and
the wireless coil is capable of resonating under a radio frequency field generated by the transmitting coil of the magnetic resonance imaging system to produce a focal field, wherein a coverage area of the focal field is smaller than a coverage area of the radio frequency field.

2. The wireless coil according to claim 1, wherein two adjacent magnetic coupling units (20) among the one or more magnetic coupling units partially overlap.

3. The wireless coil according to claim 1 or claim 2, wherein a diameter of each magnetic coupling unit (20) among the one or more magnetic coupling units is in a range of 5 cm to 20 cm.

4. The wireless coil according to any one of claims 1 to 3, wherein the flexible member (10) is a wearable flexible member;
a shape of the wearable flexible member matches a facial contour of a subject to be scanned using the magnetic resonance imaging system; preferably
in a state where the wearable flexible member is worn on a face of the subject, the one or more magnetic coupling units (20) cover an oral region of the subject.

5. The wireless coil according to any one of claims 1 to 4, further comprising:
an insulating spacer (30) disposed in an overlapping region of two adjacent magnetic coupling units (20) among the one or more magnetic coupling units.

6. The wireless coil according to any one of claims 1 to 5, wherein each of the one or more magnetic coupling units (20) is further provided with one or more tuning elements, the one or more tuning elements enabling the each of the one or more magnetic coupling units (20) to resonate at a frequency of the radio frequency field; preferably
the one or more tuning elements of one of the one or more magnetic coupling units are uniformly arranged along the one of the one or more magnetic coupling units (20).

7. The wireless coil according to any one of claims 1 to 6, wherein each of the one or more magnetic coupling units (20) is further provided with a protection device, the protection device being configured to control the each of the one or more magnetic coupling units (20) to detune when an induced current on the each of the one or more magnetic coupling units (20) exceeds a preset current range; preferably an external interface is configured to enable the protection device to control the each of the one or more magnetic coupling units (20) to detune in a wired connection manner.

8. The wireless coil according to any one of claims 1 to 7, wherein the flexible member (10) covers an abdomen of a subject to be scanned using the magnetic resonance imaging system, the one or more magnetic coupling units (20) are arranged in two rows along a head-to-foot direction of the subject, and each of the two rows includes three magnetic coupling units (20) arranged adjacent to each other from left to right.

9. The wireless coil according to any one of claims 1 to 8, wherein each of the one or more magnetic coupling units (20) is further provided with a protection device, and the protection device is configured to control the each of the one or more magnetic coupling units (20) to switch from a resonant state to a detuned state when a temperature of the each of the one or more magnetic coupling units (20) exceeds a set threshold.

10. A magnetic resonance imaging system, comprising:
a support cylinder providing an accommodation cavity, the accommodation cavity being configured to accommodate a subject;
a transmitting coil, disposed on the support cylinder and located on an outer surface of the support cylinder, for generating a radio frequency field; and
a wireless coil according to claims 1-9.

11. The magnetic resonance imaging system according to claim 10, wherein the flexible member is configured to adhere to at least one of an abdomen, a chest, or a face of the subject, or the flexible member is configured to wrap at least one of a head, a knee joint, or an ankle of the subject.

12. The magnetic resonance imaging system according to claim 10 or claim 11, wherein each of the one or more magnetic coupling units (20) is further provided with a protection device, and the protection device is configured to control the each of the one or more magnetic coupling units (20) to switch from a resonant state to a detuned state when a temperature of the each of the one or more magnetic coupling units (20) exceeds a set threshold.

13. A control method for a magnetic resonance imaging system, wherein the magnetic resonance imaging system includes a transmitting coil and a wireless coil, the transmitting coil and the wireless coil being disposed separately from each other, and the wireless coil being capable of covering at least a portion of a subject, wherein the control method comprises:
controlling the transmitting coil to be in a transmission mode to transmit a radio frequency field to the subject;
controlling the wireless coil to resonate under the radio frequency field to produce a focal field, the focal field being configured to excite nuclei of the at least a portion of the subject; and
controlling the transmitting coil to be in a reception mode to receive a magnetic resonance signal from the organ or the tissue of the subject.

14. The control method according to claim 13, wherein the wireless coil includes one or more magnetic coupling units (20), and the one or more magnetic coupling units (20) are distributed in rows and columns to form an array structure; and
the wireless coil is configured to adhere to at least one of an abdomen, a chest, or a face of the subject, or the wireless coil is configured to wrap at least one of a head, a knee joint, or an ankle of the subject; preferably,
wherein the controlling the transmitting coil to be in a transmission mode to transmit a radio frequency field to the examination subject includes:
controlling each of the one or more magnetic coupling units (20) to detune via a protection device of the each of the one or more magnetic coupling units (20), more preferably, the controlling each of the one or more magnetic coupling units (20) to detune via a protection device of the each of the one or more magnetic coupling units (20) includes:
enabling the protection device to control the each of the one or more magnetic coupling units to detune in a wired connection manner via an external interface provided on the wireless coil.

15. The control method according to claim 13 or claim 14, further comprising:
monitoring a temperature of the wireless coil, and
in response to a determination that the temperature of the wireless coil exceeds a set threshold, controlling the wireless coil to switch from a resonant state to a detuned state.
